(19)

**Europäisches Patentamt**

**European Patent Office**

**Office européen des brevets**

(11) **EP 4 485 683 A1**

(12) **EUROPEAN PATENT APPLICATION**

(43) Date of publication:
**01.01.2025 Bulletin 2025/01**

(21) Application number: **23210873.8**

(22) Date of filing: **20.11.2023**

(51) International Patent Classification (IPC):
**H01P 3/12** *(2006.01)*     **H01L 23/66** *(2006.01)*
**H01P 5/107** *(2006.01)*

(52) Cooperative Patent Classification (CPC):
**H01P 3/121; H01L 23/522; H01L 23/66;**
**H01P 5/107;** H01L 2223/6627

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **27.06.2023 US 202318342112**

(71) Applicant: **Intel Corporation**
**Santa Clara, CA 95054 (US)**

(72) Inventors:
• **Guizan, Carla**
**81541 Munich (DE)**

• **Baumgartner, Peter**
**81929 Munich (DE)**
• **Langenbuch, Michael**
**81825 Munich (DE)**
• **Virupakshappa, Mamatha**
**81541 Munich (DE)**
• **Jensen, Jonathan**
**Portland, 97229 (US)**
• **Sachithanandan, Roshini**
**81545 Munich (DE)**
• **Riess, Philipp**
**81541 Munich (DE)**

(74) Representative: **Goddar, Heinz J.**
**Boehmert & Boehmert**
**Anwaltspartnerschaft mbB**
**Pettenkoferstrasse 22**
**80336 München (DE)**

(54) **INTEGRATED WAVEGUIDES FOR SEMICONDUCTOR TECHNOLOGY**

(57)     Waveguide structures are built into integrated circuit devices using standard processing steps for semiconductor device fabrication. A waveguide may include a base, a top, and two side walls. At least one of the walls (e.g., the base or the top) may be formed in a metal layer. The base or top may be patterned to provide a transition to a planar transmission line, such as a coplanar waveguide. The side walls may be formed using vias.

**EP 4 485 683 A1**

## Description

Technical Field

This disclosure relates generally to the field of integrated circuit (IC) structures and devices, and more specifically, to waveguides formed at least partially in metal layers of an IC.

Background

Planar transmission lines are typically used in radio frequency (RF) systems. For signals on the higher end of the RF spectrum (e.g., above 80 GHz or above 100 GHz), the losses can be significant along planar transmission lines. Losses at high frequency combined with the low gain of active transistors can make it difficult to implement high power, high frequency circuits.

Waveguide-type transmission lines have lower loss propagation than planar transmission lines, and therefore a higher Q-factor, where Q-factor refers to energy stored to losses ratio. Waveguides have been explored for improving transmission on and between ICs. However, previous waveguides use different processing methods from standard semiconductor fabrication processes (e.g., complementary metal-oxide-semiconductor (CMOS) processes), which makes their incorporation into ICs complex and expensive.

Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.

FIG. 1 is a perspective view of a waveguide formed in an IC device, according to some embodiments of the present disclosure.
FIG. 2 is a perspective view of a waveguide formed across multiple layers of an IC device, according to some embodiments of the present disclosure.
FIG. 3 is a perspective view of a rectangular waveguide with a transition to or from a coplanar waveguide, according to some embodiments of the present disclosure.
FIG. 4 is a exploded perspective view of a rectangular waveguide with a transition to or from a coplanar waveguide in a different layer from the rectangular waveguide, according to some embodiments of the present disclosure.
FIG. 5 is a flowchart illustrating an example processing method for forming a waveguide, according to some embodiments of the present disclosure.
FIGs. 6A-6F illustrate various steps in the processing method of FIG. 5, according to some embodiments of the present disclosure.
FIG. 7 is a perspective view of a waveguide formed in an IC device with via side walls, according to some embodiments of the present disclosure.
FIG. 8 is a flowchart illustrating an example processing method for forming a waveguide with via side walls, according to some embodiments of the present disclosure.
FIGs. 9A-9D illustrate various steps in the processing method of FIG. 8, according to some embodiments of the present disclosure.
FIGS. 10A and 10B are top views of a wafer and dies that include an integrated waveguide in accordance with any of the embodiments disclosed herein.
FIG. 11 is a cross-sectional side view of an IC device that may include an integrated waveguide in accordance with any of the embodiments disclosed herein.
FIG. 12 is a cross-sectional side view of an IC device assembly that may include an integrated waveguide in accordance with any of the embodiments disclosed herein.
FIG. 13 is a block diagram of an example computing device that may include an integrated waveguide in accordance with any of the embodiments disclosed herein.

Detailed Description

*Overview*

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Planar transmission lines are widely used in semiconductor RF systems. However, losses along planar transmission lines, which increase with frequency, impact the overall performance, and limit the power of the system. As technologies develop to take advantage of higher parts of the RF spectrum, such as 80 GHz for automotive radar and above 100 GHz for 6G, the losses become more pronounced.

Waveguide communications channels have been used in certain specialized systems and products where planar transmission lines are inadequate, such as satellite systems and other high-power systems, and precision test applications. In these applications, transmission lines are implemented as waveguides, which can handle higher power and have lower losses than planar transmission lines. Waveguides have also been integrated into IC systems. However, waveguides are typically created using separate processing steps, e.g., as optical waveguides formed in a crystal layer.

The waveguides described herein can be integrated into a standard semiconductor process. At relatively high frequencies, e.g., at frequencies above 100 GHz, the dimensions of the waveguides can fit into a semiconductor device stack. A circuit design that incorporates such waveguides can benefit from lower losses, which are especially critical for interconnects between various subsystems. Additionally, state-of-the-art multi die systems, where the connections can be even longer, can use the waveguides described herein to reduce the losses even further.

For purposes of illustrating the waveguides integrated in semiconductor devices described herein, it may be useful to first understand how frequency relates to waveguide dimensions, and specifically, how higher frequencies allow for miniaturization of waveguides that can fit in an IC device. The following foundational information may be viewed as a basis from which the present disclosure may be properly explained. Such information is offered for purposes of explanation only and, accordingly, should not be construed in any way to limit the broad scope of the present disclosure and its potential applications.

A waveguide, as its name suggests, is a conductive structure (usually rectangular or circular) that guides or transports electromagnetic waves from one point to another. One can visualize this as the waves travelling inside the structure in a direction perpendicular to the rectangular or circular cross-section. The waveguide has conductive side walls and a dielectric filling. In the cross-section of a rectangular waveguide, a is the width, b the height, and $\varepsilon$ and $\mu$ are the permittivity and permeability of the filling material, respectively. The dimensions and material limit which modes (type of waves) and at which frequency they propagate. In an example where the width a is twice the height b (i.e., a = 2b), the cutoff frequency for the first transverse electric mode of a rectangular waveguide is given by the following equation:

$$f_{c10} \approx \frac{1}{2a\sqrt{\mu\varepsilon}} = \frac{c}{2a\sqrt{\varepsilon_r}}$$

where $f_{c10}$ is the cutoff frequency, $\varepsilon_r$ is the relative permittivity, and c is the speed of light. A wave propagates in a waveguide if it is above the cutoff frequency. For example, the D-band (110 GHz - 170 GHz) air-filled waveguide of dimensions 1.65 x 0.826 mm$^2$ has a cutoff frequency of 90.8 GHz. If the waveguide is instead filled with a dielectric such as silicon dioxide, which has a relative permittivity $\varepsilon_r$ of 3.9, the same cutoff frequency would be achieved with half the dimensions: 0.83 x 0.42 mm$^2$. The dimensions reduce further for higher frequencies, or for materials with higher permittivity, allowing their inclusion in a semiconductor chip. Additionally, certain semiconductor materials, such as silicon, are not lossy at high frequencies, but instead behave like dielectrics.

In the following detailed description, various aspects of the illustrative implementations will be described using terms commonly employed by those skilled in the art to convey the substance of their work to others skilled in the art.

For example, the term "interconnect" may be used to describe any element formed of an electrically conductive material for providing electrical connectivity to one or more components associated with an IC or/and between various such components. In general, the term "interconnect" may refer to both conductive traces (also sometimes referred to as "lines" or "trench contacts") and conductive vias. In general, in context of interconnects, the term "conductive trace" may be used to describe an electrically conductive element isolated by an insulator material (e.g., a low-k dielectric material) that is provided within the plane of an IC die. Such traces are typically stacked into several levels, or several layers, of metallization stacks. On the other hand, the term "via" may be used to describe an electrically conductive element that interconnects two or more traces of different levels. To that end, a via may be provided substantially perpendicularly to the plane of an IC die and may interconnect two traces in adjacent levels or two traces in not adjacent levels. A term "metallization stack" may be used to refer to a stack of one or more interconnects for providing connectivity to different circuit components of an IC chip. Sometimes, traces and vias may be referred to as "conductive traces" and "conductive vias", respectively, to highlight the fact that these elements include electrically conductive materials such as metals.

Interconnects as described herein may be used for providing connectivity to one or more components associated with an IC or/and between various such components, where, in various embodiments, components associated with an IC may include, for example, transistors, diodes, power sources, resistors, capacitors, inductors, transformers, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

In another example, the terms "package" and "IC package" are synonymous, as are the terms "die" and "IC die," the term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. The term "circuit" may be used to describe one or more passive and/or active components that are arranged to cooperate with one another to provide a desired function.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

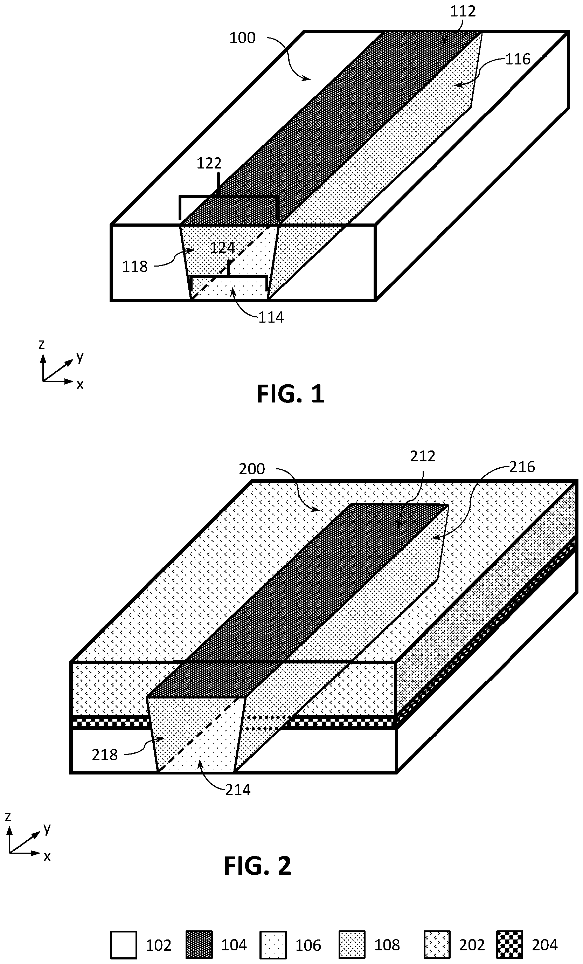

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGs. 1A-1B, such a collection may be referred to herein without the letters, e.g., as "FIG. 1."

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g. logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

### *Example Integrated Waveguides*

FIG. 1 is a perspective view of a waveguide 100 formed in an IC device, according to some embodiments of the present disclosure. A number of elements referred to in the description of FIGs. 1-4, FIGs. 6A-7, and FIGs. 9A-9D with reference numerals are illustrated in these figures with different patterns, with a legend at the bottom of the page showing the correspondence between the reference numerals and patterns. For example, the legend illustrates that FIG. 1 uses different patterns to show a support structure 102, a first conductor 104, a second conductor 106, and a third conductor 108.

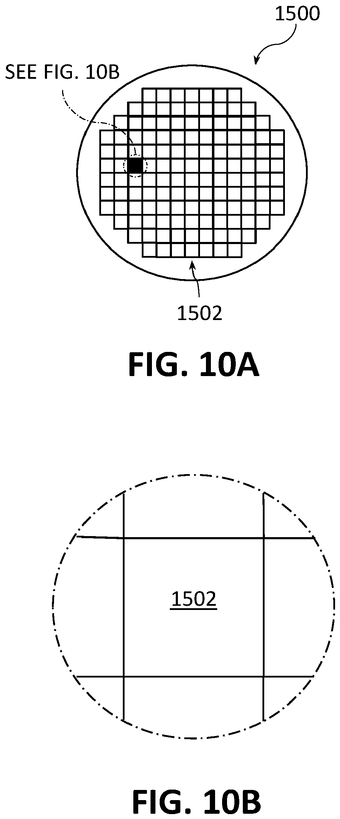

The waveguide 100 is formed in a support structure 102. In general, implementations of the present disclosure may be formed or carried out on a support structure, e.g., the support structure 102 illustrated in FIG. 1. The support structure 102 may be, e.g., a substrate, a die, a wafer, or a chip. For example, the support structure may be the wafer 1500 of FIG. 10A, discussed below, and may be, or be included in, a die, e.g., the singulated die 1502 of FIG. 10B, discussed below. The

7     **EP 4 485 683 A1**     8

support structure 102 extends along the x-y plane in the coordinate system shown in FIG. 1.

In some embodiments, the support structure 102 is or includes a substrate, and the waveguide 100 is formed substantially within the substrate. In some embodiments, the waveguide is formed at least partially within a substrate and partially within one or more additional layers formed over the substrate, e.g., a substrate and a device layer, or a substrate and one or more metal layers. An example in which a waveguide is formed across multiple layers of a device is illustrated in FIG. 2.

In general, a waveguide may be formed within or over a support structure that may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support structure may be a printed circuit board (PCB) substrate. Although a few examples of materials from which the substrate may be formed are described here, any material that may serve as a foundation upon and/or within a waveguide may be formed, as described herein, falls within the spirit and scope of the present disclosure.

The waveguide 100 of FIG. 1 includes a top 112, a base 114, and a pair of side walls 116 and 118. The top 112, also referred to as a top wall 112, is formed from the first conductor 104. The first conductor 104 may include any one or more conductive materials, such as copper (e.g., PCC or FGC), manganese, titanium, gold, silver, palladium, nickel, aluminum, copper and aluminum (e.g., in the form of a copper aluminum alloy), tantalum (e.g., tantalum metal, or tantalum and nitrogen in the form of tantalum nitride), cobalt, cobalt and iron (e.g., in the form of a cobalt iron alloy), or any alloys of any of the foregoing (e.g., copper, manganese, and nickel in the form of manganin).

The base 114, also referred to as a base wall 114 or bottom wall 114, is formed from the second conductor 106. The second conductor 106 may include any of the conductive materials described with respect to the first conductor 104. In some embodiments, the first conductor 104 and the second conductor 106 are a same material. In some embodiments, the second conductor 106 is a back metallization layer on a back side of the support structure 102. The back metallization layer may extend across the back side of the support structure 102, including under areas where the waveguide 100 is not formed. One or more device layers and/or metal layers (e.g., a metal layer in which the top 112 is formed) may be formed over a front side of the support structure 102.

The side walls 116 and 118 are formed from the third conductor 108. The third conductor 108 may include any of the conductive materials described with respect to the first conductor 104. In some embodiments, the first conductor 104, the second conductor 106, and the third conductor 108 are a same material. In some embodiments, the second conductor 106 is a different material (e.g., a material used for a back metallization layer), while the first conductor 104 and the third conductor 108 are a same material (e.g., copper or another metal used in a fabrication process for semiconductor devices).

The four walls 112, 114, 116, and 118 form boundaries of an area along which a wave (e.g., and RF wave) can travel, as described above. The waveguide 110 may be filled with a fill material, which is not specifically shown in FIG. 1 to better illustrate the waveguide walls. The fill may be a dielectric material, such as silicon dioxide. Alternatively, the fill may be a semiconductor material that, at high frequencies, acts as a dielectric material, such as silicon. More generally, the fill may include hafnium, silicon, oxygen, titanium, tantalum, lanthanum, aluminum, zirconium, barium, strontium, yttrium, lead, scandium, niobium, and zinc. Examples of fill materials include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

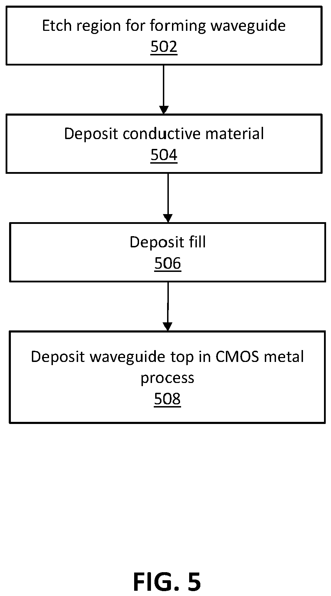

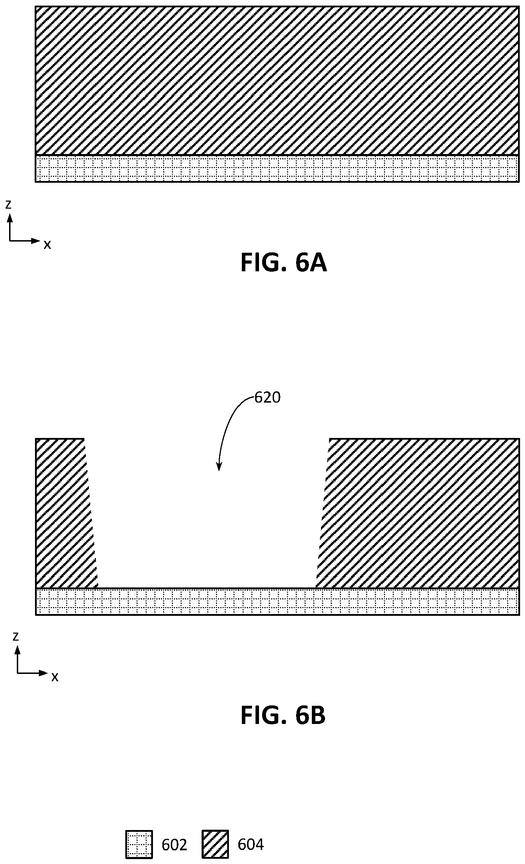

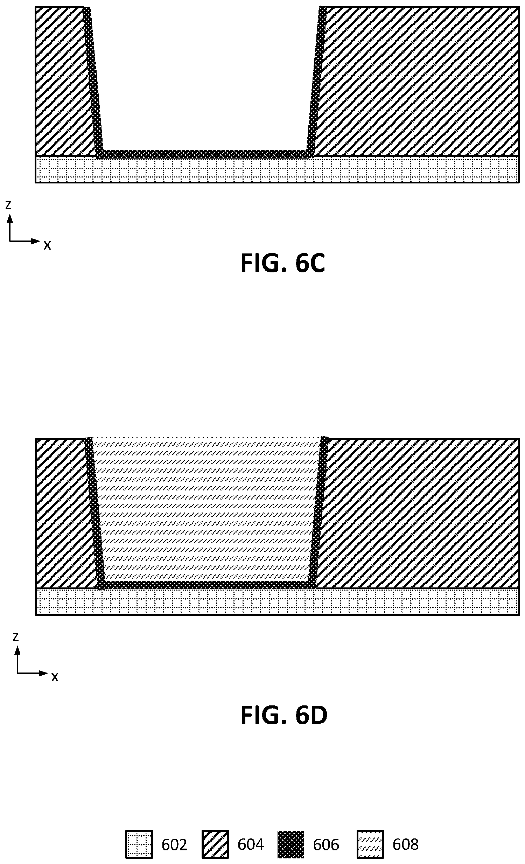

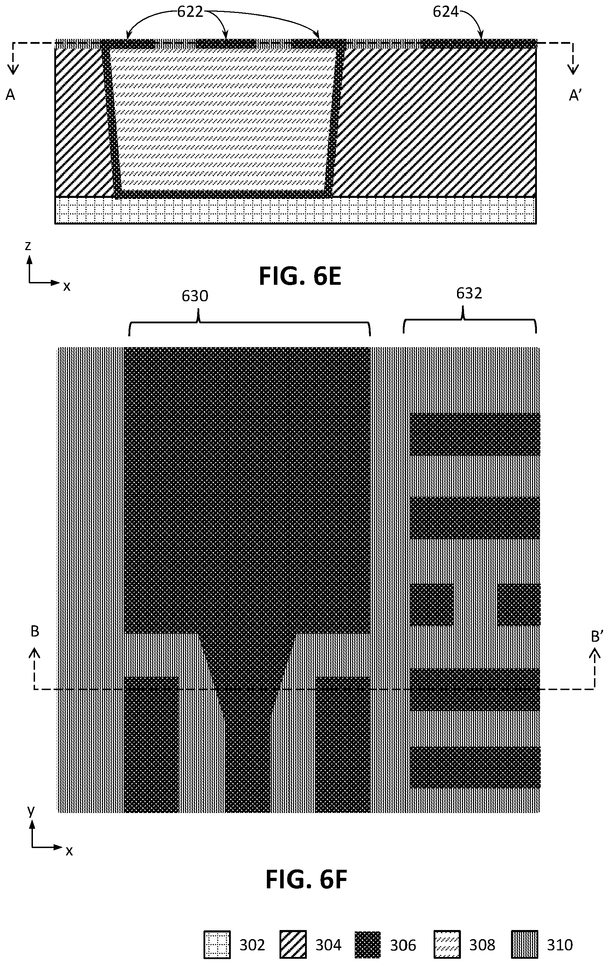

In one example, the support structure 102 is a semiconductor in which a plurality of transistor devices are formed, in areas of the support structure 102 that are outside the waveguide 100. The top 112 may be in a first metal layer formed over the support structure 102. Thus, the top 112 may be deposited in the process used to deposit a metal for forming interconnect structures in the first metal layer. An example process for forming the waveguide 100 is illustrated in FIGs. 5 and 6.

In the example shown in FIG. 1, the waveguide 100 is substantially rectangular. More specifically, the waveguide 100 has a rectangular cross-section through the x-z plane in the example coordinate system. In the depiction shown, the side walls 116 and 118 are angled slightly, e.g., an angle between each of the side walls 116 and 118 and the base 114 and/or the top 112 are between 2° and 20° or within a smaller range, e.g., between 2° and 5°, or between 5° and 10°. In this embodiment, the base 114 has a somewhat smaller surface area than the top 112. The angled side walls 116 and 118 may be created by an etching process for removing a portion of the support structure 102 to form the waveguide 110; the etching process may result in angled side walls 116 and 118.

In other embodiments, the side walls 116 and 118 are substantially vertical (e.g., an angle between the side wall 116 or 118 and the base 114 is less than 5°, less than 3°, or less than 1°, and/or an angle between the side wall 116 or 118 and the top 112 is less than 5°, less than 3°, or less than 1°). In such embodiments, a width 122 of the top 112 (where width is a distance in the x-direction between the side wall 116 and the side wall 118) is substantially the same as a width 124 of the base 114, e.g., the widths 122 and 124 of the top 112 and the base 114 are within 10%, within 5%, within 3%, or within 1% of each other.

FIG. 2 is a perspective view of a waveguide formed across multiple layers of an IC device, according to some embodiments of the present disclosure. As noted above, an integrated waveguide may extend across multiple device layers, e.g., a support structure 102 and one or more metal layers. In the example shown in FIG. 2, a waveguide 200 is partially within the support structure 102 and partially within a stack of metal layers 202 over the support structure 102. One or more device layers 204 may be formed between the metal layers 202 and the support structure 102. The metal layers 202 may provide a metallization stack, as described above.

The device layer 204 may include features of one or more transistors (e.g., metal oxide semiconductor field-effect transistors (MOSFETs)) formed on the support structure 102. The device layer 204 may include, for example, one or more source and/or drain (S/D) regions, a gate to control current flow in the transistors between the S/D regions, and one or more S/D contacts to route electrical signals to/from the S/D regions. Transistors in the device layer may be of any type and configuration such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors. The device layer 204 may include alternative or additional types of devices, such as capacitors, inductors, diodes, resistors, memory devices, transformers, etc.

In the example of FIG. 2, the waveguide 200 has a top (or top wall) 212, a base (or base wall or bottom wall) 214, and a pair of side walls 216 and 218. The top 212 is formed from the first conductor 104, the base 214 is formed from the second conductor 106, and the side walls 216 and 218 are formed from the third conductor 108. The arrangement and composition of the top 212, the base 214, and the side walls 216 and 218 may be similar to the top 112, the base 114, and the side walls 116 and 118 of FIG. 1. For example, the base 214 may be a portion of a back metallization layer under the support structure 102. The waveguide 200 may include a fill material between the top 212, the base 214, and the pair of side walls 216 and 218, as described with respect to FIG. 1.

In this example, the top 212 is formed in a metal layer over the support structure 102 and over the device layer 204. The top 212 may be deposited in the process used to deposit a metal for forming interconnect structures in one of the metal layers 202. The side walls 216 and 218 each extend through a portion of the metal layers 202, through the device layer 204, and through at least a portion of the support structure 102.

In the example shown in FIG. 2, the side walls 216 and 218 extend through the full support structure 102, with the base 214 at the bottom of the support structure 102. In other embodiments, the base 214 is above the bottom of the support structure 102, e.g., a portion of the support structure 102 is etched to form the waveguide 200, while a portion of the support structure 102 remains under the waveguide 200 and, in particular, under the base 214.

In another example, a waveguide may be formed fully within a metallization stack. For example, in FIG. 2, the area 102 may instead represent a first metal layer or set of metal layers (which may be formed over a support structure that is not depicted), the area 204 may represent another metal layer, and the area 202 may represent another metal layer.

### Example Waveguide Transitions

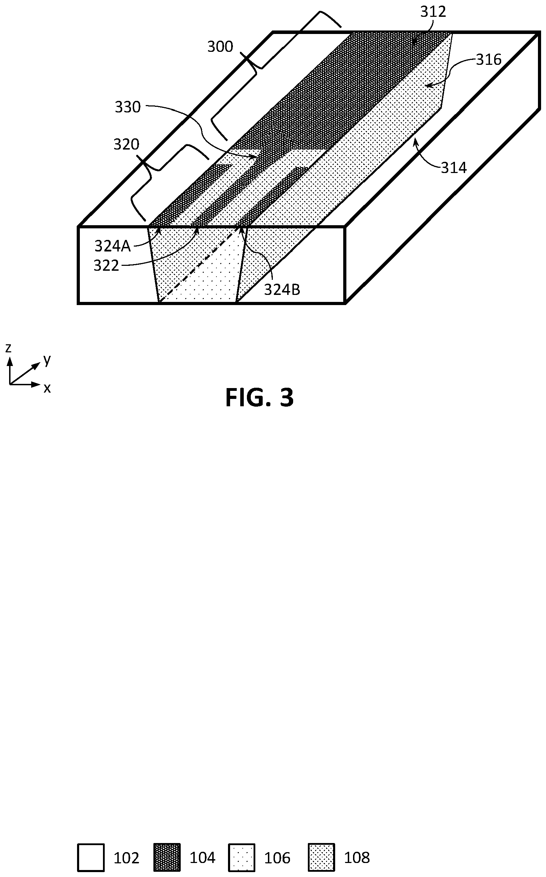

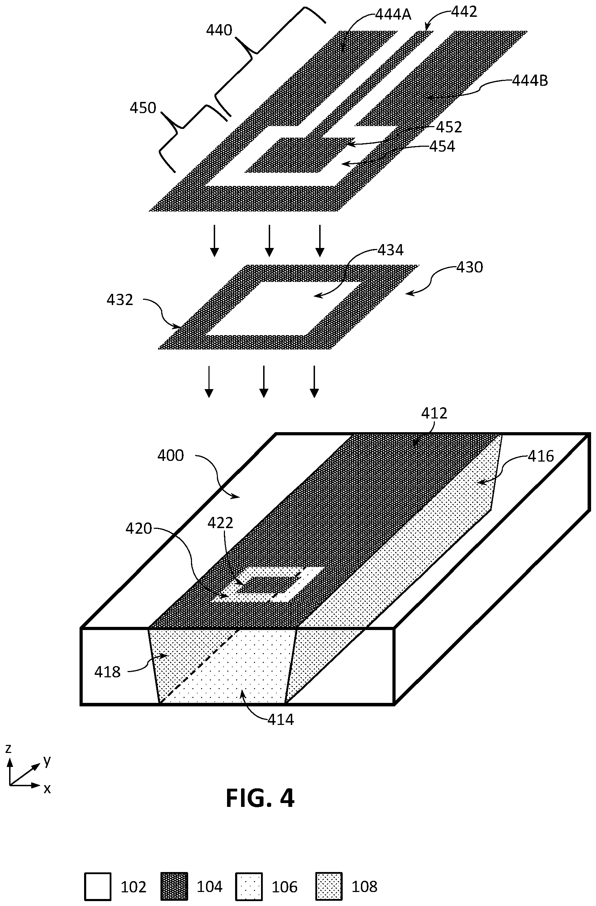

The waveguides described herein, such as the waveguides 100 and 200, may include transitions to planar transmission lines, such as coplanar waveguides. The transition regions may be formed using a standard process, such as metal deposition steps. FIGs. 3 and 4 illustrate two example transitions between a coplanar waveguide and a rectangular waveguide.

FIG. 3 is a perspective view of a rectangular waveguide with a transition to or from a coplanar waveguide, according to some embodiments of the present disclosure. FIG. 3 illustrates a rectangular waveguide 300 coupled to a coplanar waveguide 320 by a transition region 330. A signal may travel along the coplanar waveguide 320 to the rectangular waveguide 300 and continue to travel along the rectangular waveguide 300. Alternatively, a signal may travel in the opposite direction, along the rectangular waveguide 300 and to the coplanar waveguide 320, and continue travelling along the coplanar waveguide 320.

The rectangular waveguide 300 is similar to the waveguide 200 or 100, with a top 312, a base 314, a first side wall 316, and a second side wall opposite the first side wall 316. The coplanar waveguide 320 has a conductive strip 322 for conducting the signal, and a pair of ground planes 324A and 324B on either side of the conductive strip 322. The conductive strip 322 and ground planes 324A and 324B are formed from the third conductor 108, i.e., the same conductor as the top 312 of the rectangular waveguide 300. A dielectric material, not specifically shown in FIG. 3, is between the conductive strip 322 and each of the ground planes 324A and 324B.

The transition region 330 couples the coplanar waveguide 320 to the rectangular waveguide 300. In particular, the transition region 330 couples the conductive strip 322 of the coplanar waveguide 320 to the rectangular waveguide 300 to transfer a signal between the conductive strip 322 and the rectangular waveguide 300. In this example, the transition region 330 is also formed from the third conductor 108. The transition region 330 and coplanar waveguide 320 may be deposited in a same deposition process as the top 312 of the rectangular waveguide 300.

In this example, the coplanar waveguide 320 and the transition 330 are formed in the same layer as the top 312. For example, the coplanar waveguide 320 and transition region 330 may be formed in a first metal layer over the support structure 102 (e.g., in the same the layer with the top 112 in FIG. 1), or the coplanar waveguide 320 and transition region 330 may be formed in a higher metal layer in the metallization stack 202 (e.g., in the same layer with the top 212 in FIG. 2).

In a different embodiment, the coplanar waveguide 320 and transition region 330 are formed in the same layer as the base 314, e.g., in a lower metal layer than the top 312. In yet another embodiment, the coplanar waveguide 320 is arranged at a 90° angle or approximately 90° to the arrangement shown (i.e., in the y-z plane or slightly offset from the y-z plane) and extends in the plane of one of the side walls, e.g., side wall 316.

In the example of FIG. 3, the base and side walls of the rectangular waveguide 300 extend into the portion in the y-direction in which the coplanar waveguide 320 is. In other examples, the base 314 and/or the side walls (e.g., the side wall 316) are not in the region for the coplanar waveguide 320. The waveguide 300 may include a fill material, as described with respect to FIG. 1. The fill material may also be in a region under the transition region 330, and/or under the conductive strip 322 and ground planes 324A and 324B of the coplanar waveguide 320. Alternatively, the coplanar waveguide 320 may be formed directly on the support structure 102 or another layer in which the top 312, conductive strip 322, and ground planes 324A and 324B are formed, e.g., in a metal layer (as described with respect to FIG. 2).

FIG. 4 is a exploded perspective view of a rectangular waveguide with a transition to or from a coplanar waveguide in a different layer from the rectangular waveguide, according to some embodiments of the present disclosure. FIG. 4 illustrates a rectangular waveguide 400, which may be similar to the waveguide 100 or the waveguide 200 described above. The waveguide 400 includes a top 412, a base 414, a first side wall 416, and a second side wall 418 opposite the first side wall 416. The waveguide 400 further includes a port 420 for receiving a signal from another portion of an IC device, or transmitting a signal to another portion of an IC device. In particular, the port 420 allows signal transmission from or to a coplanar waveguide 440. The port 420 includes a conductive patch 422 surrounded by an open region, which may be filled by a dielectric material (not specifically illustrated). This open region is further surrounded by the top 412 of the waveguide 400. The port 420 may be formed at one end of the waveguide 400.

The coplanar waveguide 440 includes a conductive strip 442 with two ground planes 444A and 444B on either side of the conductive strip 442, where a dielectric material is between the conductive strip 442 and each of the ground planes 444A and 444B. The coplanar waveguide 440 is coupled to a port 450 which includes a conductive patch 452 coupled to the conductive strip 442. Other than the connection to the conductive strip 442, the conductive patch 452 is surrounded by an open region 454, which may be filled with a dielectric material. The ground planes 444A and 444B extend around the open region 454.

The coplanar waveguide 440 is formed in a different metal layer from the top 412 of the rectangular waveguide 400. A transition layer 430 is between the port 450 extending from the coplanar waveguide 440 and the port 420 of the waveguide 400. The transition layer 430 includes a rectangular or square portion 432 of conductive material (e.g., the third conductor 108) surrounding an open area 434, which may be filled with a dielectric material.

The top 412 of the rectangular waveguide 400 (including the port 420), the transition layer 430, and the coplanar waveguide 440 (including the port 450) may each be formed in a different metal layer of a metallization stack. For example, if the top 412 is formed in a first metal layer, the transition layer 430 may be formed in a second metal layer, and the coplanar waveguide 440 in a third metal layer. The view illustrated in FIG. 4 is exploded to more clearly illustrate the layers; in a device, the gaps between the top 412 of the rectangular waveguide 400, the transition layer 430, and the coplanar waveguide 440 are smaller, as indicated by the arrows in FIG. 4.

In the example shown in FIG. 4, the conductive features of the top 412, transition layer 430, and coplanar waveguide 440 and port 450 are formed from the third conductor 108. In other examples, one or more of the illustrated layers may include different conductive materials.

### Example Method for Forming a Waveguide

FIG. 5 is a flowchart illustrating an example processing method for forming a waveguide, according to some embodiments of the present disclosure. FIGs. 6A-6F illustrate various steps in the processing method of FIG. 5, according to some embodiments of the present disclosure. In particular, FIGs. 6A-6F illustrate a cross-section of one example waveguide.

At 502, a region for forming a waveguide is etched. The region may be etched from a support structure, e.g., the support structure 102. Alternatively or additionally, the region may be etched from one or more metal layers, e.g., the metal layers 202, and/or one or more device layers, e.g., the device layer 204.

FIG. 6A illustrates a region 604 in which a waveguide is formed. The region 604 may be a support structure 102 or a portion of a support structure 102, i.e., an upper portion of a support structure 102. The region 604 may be a metallization stack, e.g., the metal layers 202. The region 604 may include multiple different types of layers, e.g., metal layers 202 and one or more device layers 204, or metal layers 202, a device layer 204, and an upper portion of a support structure 102. The region 604 is formed over a base structure 602. In one embodiment, the base structure 602 is a back side metallization layer. In another embodiment, the base structure 602 is a support structure 102 or a portion (e.g., a lower region) of a support structure 102.

FIG. 6B illustrates a region 620 etched into the region 604. The region 620 has a rectangular or substantially rectangular shape. The region 620 may be patterned and etched using any etching process for removing material from the region 604. A combination of etch chemistries and/or techniques may be used if the region 604 includes multiple layers of different material, e.g., a first etch process may be used to remove a dielectric material (e.g., from metallization layers), and a second etch process may be used to remove a semiconductor material (e.g., from a substrate).

At 504, a conductive material is deposited in the etched region. For example, the first conductor 104 and/or second conductor 106 may be deposited to form the base and side walls of the waveguide.

FIG. 6C illustrates a conductor 606 deposited along the base and side walls of the region 620. The conductor 606 is deposited using a conformal deposition process, such as atomic layer deposition (ALD) or chemical vapor deposition (CVD). Conformal deposition generally refers to deposition of a certain coating on any exposed surface of a given structure. A conformal coating may, therefore, be understood as a coating that is applied to exposed surfaces of a given structure, and not, for example, just to the horizontal surfaces.

In the example of FIG. 6C, the conductor 606 is conformally deposited across the sides and base of the region 620. In another embodiment, a selective deposition process is used to deposit the conductor 606 on the sides of the region 620 but not on the base of the region 620 (i.e., not over the area of the region 620 bounded by the base structure 602). For example, the deposition chemistry and/or materials for the base structure 602, the region 604, and/or the conductor 606 may be selected so that the conductor 606 is only deposited on the side walls of the region 620 but not over the base structure 602. This selective deposition may be used if the base structure 602 is a metal, e.g., a back side metallization layer.

At 506, a fill material is deposited. The fill material may be a dielectric material or a semiconductor that behaves as a dielectric at intended frequencies for the waveguide, e.g., at frequencies above the cutoff frequency for the waveguide. FIG. 6D illustrates a fill material 608 filling the region 620. The fill material 608 is bounded at the bottom and sides by the conductor 606. The fill material 608 may be deposited using a conformal or non-conformal deposition process.

At 508, the waveguide top is deposited in a metal processing step or steps. For example, the waveguide top may be a portion of a standard metal layer of a process flow for semiconductor devices. A portion of the waveguide top may be patterned, e.g., to provide either of the coplanar waveguide transitions illustrated in FIGs. 3 and 4. Interconnect structures may be formed in the same layer with the waveguide top, during the same patterning and deposition process.

FIG. 6E illustrates a metal layer including a waveguide top 622 deposited over the fill material 608 and side walls of the conductor 606. In this example, the waveguide top 622 is patterned, e.g., to form a transition between a planar transmission line and a rectangular waveguide. An interconnect 624 is formed in the same layer as the waveguide top 622; the interconnect 624 may be a standard interconnect in a metal layer. The waveguide top 622 and interconnect 624 are separated by a dielectric material 610; the dielectric material 610 is also between regions of the conductor 606 in the waveguide top 622.

FIG. 6F shows a cross-section through the waveguide top 622, interconnect 624, and dielectric material 610. Specifically, FIG. 6F is a cross-section through the plane AA' in FIG. 6E, and FIG. 6E is a cross-section through the plane BB' in FIG. 6F. FIG. 6F illustrates a waveguide region 630 which includes a top of the rectangular waveguide and a patterned portion through which the cross-section of FIG. 6E is taken. FIG. 6F further includes an interconnect region 632 which includes a set of interconnect structures formed in the same layer as the waveguide top. In other embodiments, the waveguide base is additionally or alternatively in a metal layer that includes interconnect structures.

*Example Waveguide with Via Side Walls*

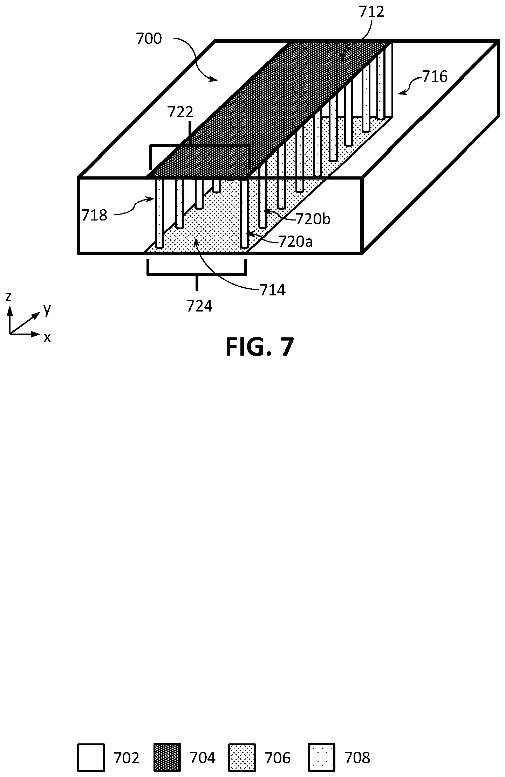

FIG. 7 is a perspective view of a waveguide 700 formed in an IC device with via side walls, according to some embodiments of the present disclosure. The waveguide 700 may be formed in a support structure 702. The support structure 702 may be similar to the support structure 102 described with respect to FIG. 1. The support structure 702 (e.g., a front face and a back face of the support structure 702) extends in the x-direction and y-direction in the coordinate system shown in FIG. 7.

In some embodiments, the support structure 702 is or includes a substrate, and the waveguide 700 is formed substantially within the substrate. The top 712 of the waveguide 700 (described further below) may be formed over the substrate, e.g., in a metal layer. In some embodiments, the waveguide 700 is formed at least partially within a substrate and partially within one or more additional layers formed over the substrate, e.g., a substrate and a device layer, or a substrate and one or more metal layers. In some other examples, the waveguide 700 may be formed fully within a metallization stack, e.g., the material 702 may be a dielectric material of a metallization stack. For example, the base 714 (described further below) may be in a first metal layer (which may be formed over a support structure that is not depicted), and the top 712 may be in a second metal layer over the first metal layer; one or more additional metal layers may be between the first metal layer and the second metal layer.

The waveguide 700 has a top 712, a base 714, and a pair of side walls 716 and 718. The top 712, also referred to as a top wall 712, is formed from a first conductor 704, which may be similar to the first conductor 104 described above. The base 714, also referred to as a base wall 714 or bottom wall 714, is formed from the second conductor 706, which may be similar to the second conductor 106 described above. The side walls 716 and 718 are each formed by a row of vias, e.g., vias 720a and 720b. Each of the vias 720 are formed from the third conductor 708. The third conductor 708 may be any of the conductor materials described above, e.g., any suitable conductor for forming a via interconnect. The third conductor 708 may be the same as the first conductor 704 and/or the same as the second conductor 706.

The top 712 and the base 714 may be similar to the top 112 and the base 114 of FIG. 1. For example, the base 714 may be a portion of a back metallization layer under the support structure 702. The waveguide 700 may include a fill material between the top 712, the base 714, and the pair of side walls 716 and 718, as described with respect to FIG. 1. In particular, the support structure 702 may form the fill material, if the top 712 is formed over the support structure 702. More generally, any materials between the base 714 and the top 712 may form the fill material. For example, if the base 714 is in a first metal layer and the top 712 is in a second metal layer, a dielectric material in the metal layers may form the fill material.

The vias 720 each extend between the top 712 and the base 714. Each via 720 extends primarily in the z-direction, i.e., in a direction perpendicular to the top 712 and the base 714. Each via 720 may taper moving from the top 712 towards the base 714, e.g., a cross-section of the via 720a where the via 720a is coupled to the top 712 is larger than a cross-section of the via 720a where the via 720a is coupled to the base 714. A first row of vias that includes the vias 720a and 720b form the first side wall 716. A second row of vias on an opposite side of the waveguide 700 from the side wall 716 form the second side wall 718. The vias 720 may be arranged at a distance that is based on the frequency of wave traveling through the waveguide; for a higher frequency wave, a shorter distance between adjacent vias may be used to contain the wave in the waveguide 700, while a longer distance between adjacent vias may be permitted for lower frequency waves. The distance between adjacent vias may also depend on the fill material.

In the example shown in FIG. 7, the waveguide 700 is substantially rectangular, i.e., the four walls 712-718 form the boundaries of a rectangular waveguide. More specifically, the waveguide 700 has a rectangular cross-section through the x-z plane in the example coordinate system. In the depiction shown, the side walls 716 and 718 extend vertically or substantially vertically. In this embodiment, the top 712 has a width 722 and the base 714 has a width 724; the two widths 722 and 724 are substantially the same, e.g., the widths 722 and 724 of the top 712 and the base 714 are within 10%, within 5%, within 3%, or within 1% of each other. The top 712 may have substantially the same surface area as the base 714. In some embodiments, one or both of the base 714 and the top 712 may extend in the x-direction and/or the y-direction in an area outside the waveguide 700. For example, the base 714 may be a back metallization layer that extends across the back side of the support structure 702.

The rectangular waveguide 700 may include a transition to or from a planar transmission line, such as a transition to or from a coplanar waveguide. The transitions between the rectangular waveguide 700 and a planar transmission line may be similar to the transition regions illustrated in FIGs. 3 and 4 and described above. As discussed above, the transition regions may be formed using standard processes, such as metal deposition steps for CMOS processing or other semiconductor fabrication processes.

*Example Method for Forming a Waveguide with Via Side Walls*

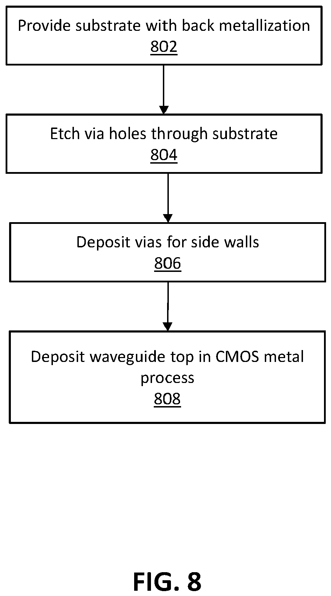

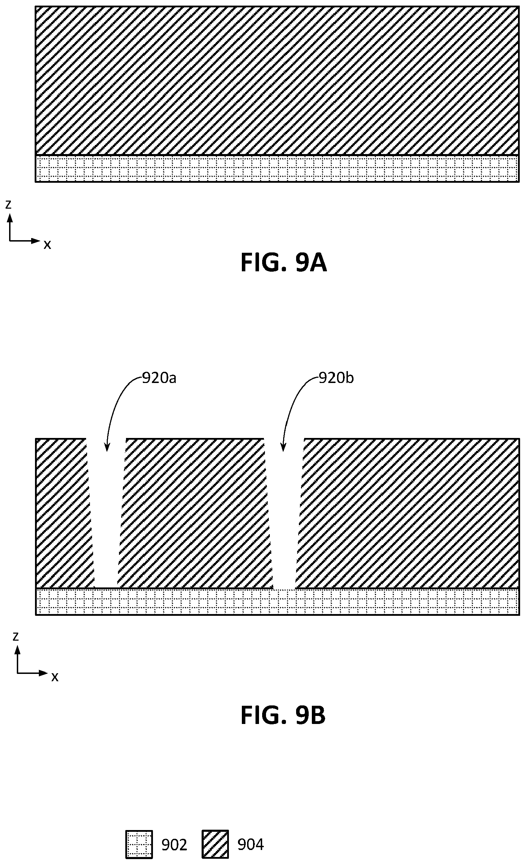

FIG. 8 is a flowchart illustrating an example processing method for forming a waveguide with via side walls, such as the waveguide 700 shown in FIG. 7, according to some embodiments of the present disclosure. FIGs. 9A-9D illustrate various steps in the processing method of FIG. 8, according to some embodiments of the present disclosure. In particular, FIGs. 9A-9D illustrate a cross-section of one example waveguide.

At 802, a substrate with back metallization is provided. FIG. 9A illustrates a back metallization layer 902 under a substrate 904. The back metallization layer 902 may be formed from any suitable metal or other conductor. The substrate 904 may be an example of the support structure described above, e.g., a silicon substrate. In some embodiments, one or more additional layers are formed over the substrate 904, e.g., one or more device layers and/or one or more metal layers, as described above.

At 804, via holes are etched through the substrate. FIG. 9B illustrates two via holes 920a and 920b etched into the substrate 904. The via holes 920 may be patterned and etched using any etching process for removing material from the substrate 904. If additional layers are formed over the substrate 904 (e.g., layers of a dielectric material in a device layer and/or one or more metal layers), a combination of etch chemistries and/or techniques may be used, e.g., a first etch process may be used to remove a dielectric material (e.g., from metallization layers), and a second etch process may be used to remove a semiconductor material (e.g., from a substrate 904). Each of the via holes 920 extends in the z-direction, perpendicular to the back metallization layer 902 and the front and back faces of the substrate 904. The illustrated via holes 920a and 920b are at different positions in the x-direction. Additional via holes 920 at the same positions in the x-direction as the via holes 920a and 920b are formed at different positions in the y-direction, i.e., into and/or out of the page in the orientation shown in FIG. 9B. The via holes form two rows, one corresponding to each of the side walls 716 and 718 illustrated in FIG. 7.

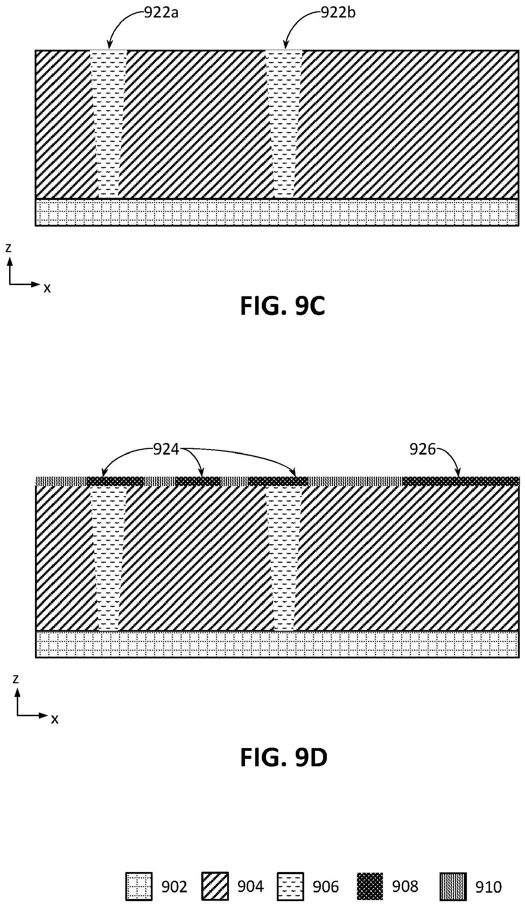

At 806, a conductive material is deposited in the etched via holes. For example, the third conductor 708 may be deposited to form the vias for the side walls 716 and 718 of the waveguide 700. FIG. 9C illustrates a conductor 906 deposited in the regions 920a and 920b. The conductor 906 may be deposited using a conformal deposition process, such as ALD or CVD, or a non-conformal deposition process. The conductor 906 forms vias 922a and 922b. Additional vias 922 are formed at different positions in the y-direction, i.e., into and/or out of the page in the orientation shown in FIG. 9C, thus forming the two side walls 716 and 718. The via 922a is one via of the side wall 718, and the via 722b is one via of the side wall 716.

At 808, the waveguide top is deposited in a metal process. For example, the waveguide top may be a portion of a standard metal layer of a process flow. Similar to the waveguide top described in FIGs. 5 and 6E, a portion of the waveguide top may be patterned, e.g., to provide either of the coplanar waveguide transitions illustrated in FIGs. 3 and 4. Interconnect structures may be formed in the same layer with the waveguide top, during the same patterning and deposition process.

FIG. 9D illustrates a metal layer including a waveguide top 924 deposited over the substrate 904 and the vias 922. The metal layer includes portions of a conductor 908 (which may be the second conductor 706 shown in FIG. 7) and portions of a dielectric 910. In this cross-section, the waveguide top 924 is patterned, e.g., to form a transition between a planar transmission line and a rectangular waveguide. An interconnect 926 is formed in the same layer as the waveguide top 924; the interconnect 926 may be a standard interconnect in a metal layer. The waveguide top 924 and interconnect 926 are separated by a dielectric material 910; the dielectric material 910 is also between regions of the conductor 908 in the waveguide top 924. A cross-section through the waveguide top 924, interconnect 926, and dielectric material 910 may be similar to FIG. 6F, discussed above.

## Example devices

The integrated waveguides disclosed herein may be included in any suitable electronic device. FIGS. 10-13 illustrate various examples of apparatuses that may include the interconnects with barrier material liners disclosed herein.

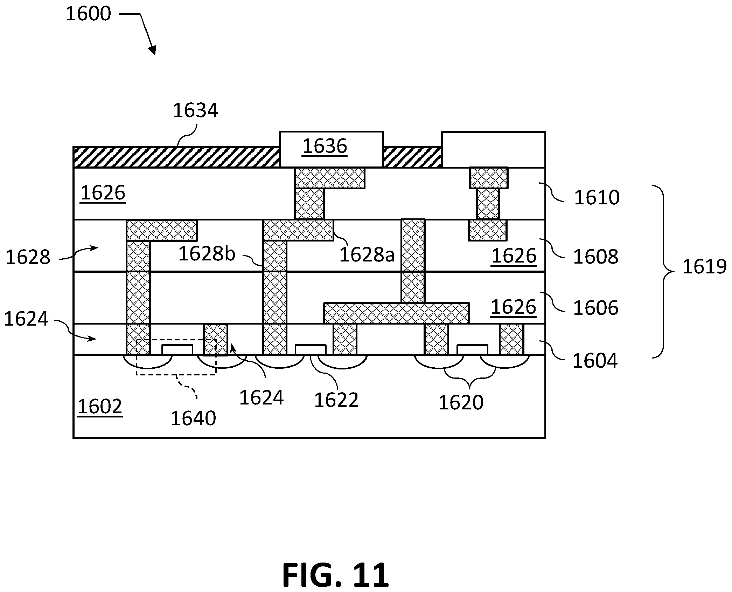

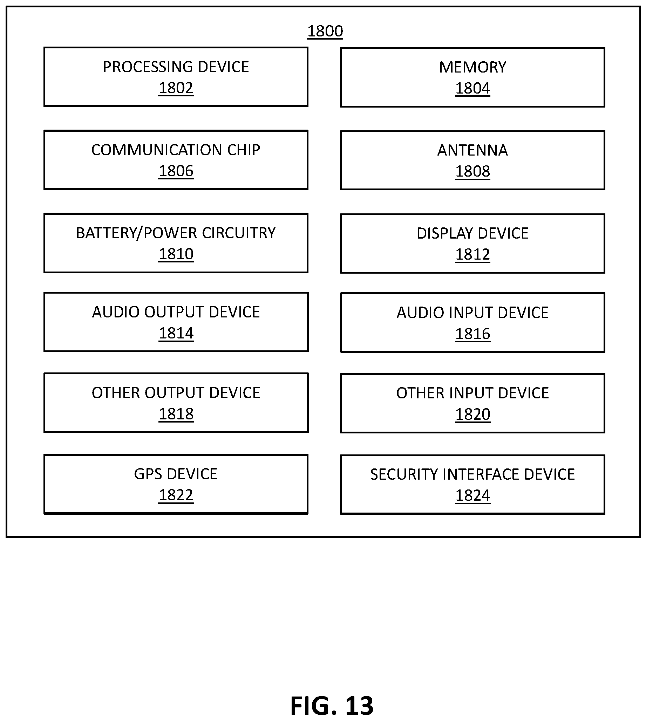

FIG. 10A and 10B are top views of a wafer and dies that include one or more IC structures with one or more integrated waveguides in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of 1-4, 6, 7, or 9, or any further embodiments of the IC structures described herein). After the fabrication of the semiconductor product is complete (e.g., after manufacture of one or more IC structures with one or more integrated waveguides as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more integrated waveguides as disclosed herein may take the form of the wafer 1500 (e.g., not singulated) or the form of the die 1502 (e.g., singulated). The die 1502 may include one or more transistors (e.g., one or more of the transistors 1640 of FIG. 11, discussed below) and/or supporting circuitry to route electrical signals to the transistors, as well as any other IC components (e.g., one or more integrated waveguides). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 13) or other logic that is configured to store information in the memory devices or execute instructions stored in the memory array.

FIG. 11 is a cross-sectional side view of an IC device 1600 that may include one or more IC structures with one or more integrated waveguides in accordance with any of the embodiments disclosed herein. The IC device 1600 may be formed on a substrate 1602 (e.g., the wafer 1500 of FIG. 9A) and may be included in a die (e.g., the die 1502 of FIG. 9B). The substrate 1602 may be any substrate as described herein. The substrate 1602 may be part of a singulated die (e.g., the dies 1502 of FIG. 9B) or a wafer (e.g., the wafer 1500 of FIG. 9A).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 11 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

Although not specifically shown in FIG. 11, the IC device 1600 may include one or more integrated waveguides at any suitable location in the IC device 1600.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 11 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 11). Although a particular number of interconnect layers 1606-1610 is depicted in FIG. 11, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 11. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 11. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

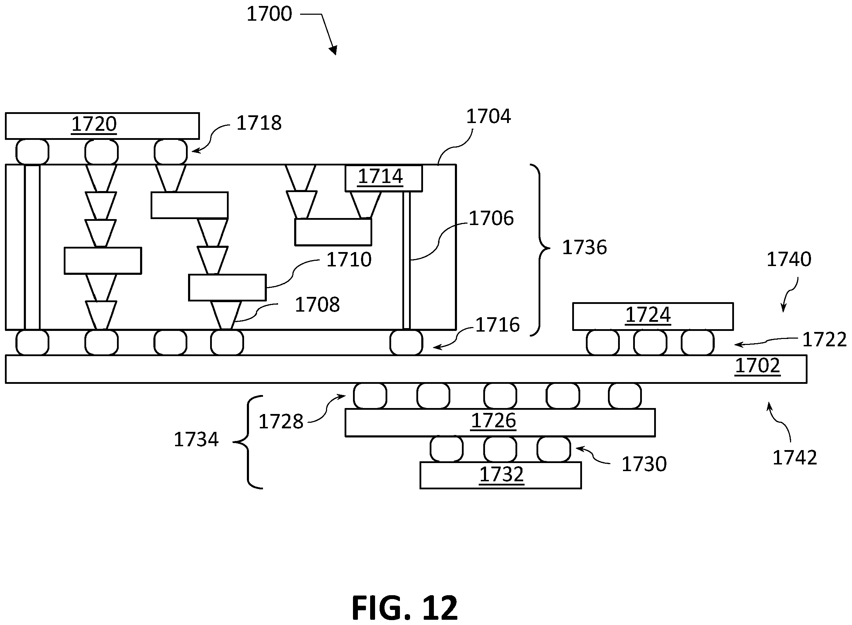

FIG. 12 is a cross-sectional side view of an IC device assembly 1700 that may include integrated waveguides in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include any of the integrated waveguides, disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 12 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 12), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 12, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 9B), an IC device (e.g., the IC device 1600 of FIG. 11), or any other suitable component. In some embodiments, the IC package 1720 may include integrated waveguides, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 12, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 12 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 13 is a block diagram of an example computing device 1800 that may include one or more components including one or more IC structures with one or more integrated waveguides in accordance with any of the embodiments disclosed herein. For example, any suitable ones of the components of the computing device 1800 may include a die (e.g., the die 1502 of FIG. 9B) having integrated waveguides as described herein. Any one or more of the components of the computing device 1800 may include, or be included in, an IC device 1600 (FIG. 11). Any one or more of the components of the computing device 1800 may include, or be included in, an IC device assembly 1700 (FIG. 12).

A number of components are illustrated in FIG. 13 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 13, but the computing device 1800 may include interface circuitry for coupling to the one or more components. For example, the computing device 1800 may not include a display device 1806, but may include display device interface circuitry (e.g., a connector and driver circuitry) to which a display device 1806 may be coupled. In another set of examples, the computing device 1800 may not include an audio input device 1824 or an audio output device 1808 but may include audio input or output device interface circuitry (e.g., connectors and supporting circuitry) to which an audio input device 1824 or audio output device 1808 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the computing device 1800 may include a communication chip 1812 (e.g., one or more communication chips). For example, the communication chip 1812 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The computing device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The computing device 1800 may include battery/power circuitry 1814. The battery/power circuitry 1814 may include one or more energy storage devices (e.g., batteries or capacitors) and/or circuitry for coupling components of the computing device 1800 to an energy source separate from the computing device 1800 (e.g., AC line power).

The computing device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1808 (or corresponding interface circuitry, as discussed above). The audio output device 1808 may include any device that generates an audible indicator, such as speakers, headsets, or earbuds, for example.

The computing device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The computing device 1800 may include a GPS device 1818 (or corresponding interface circuitry, as discussed above). The GPS device 1818 may be in communication with a satellite-based system and may receive a location of the computing device 1800, as known in the art.

The computing device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The computing device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

*Select examples*

The following paragraphs provide various examples of the embodiments disclosed herein.

Example 1 provides an IC device that includes an interconnect structure in a metal layer of the IC device, the interconnect structure including a conductive material; and a waveguide structure including a top wall, a bottom wall, and a pair of side walls, each of the walls including the conductive material, where one of the top wall and the bottom wall is in the metal layer of the IC device.

Example 2 provides the IC device of example 1, where the waveguide structure is a rectangular waveguide, and the rectangular waveguide is coupled to a coplanar waveguide.

Example 3 provides the IC device of example 2, where the one of the top wall and the bottom wall in the metal layer of the IC device is patterned to provide a transition to the coplanar waveguide.

Example 4 provides the IC device of any of the preceding examples, where a dielectric material is in a region bounded by the top wall, the bottom wall, and the pair of side walls.

Example 5 provides the IC device of any of examples 1-3, where a semiconductor material is in a region bounded by the top wall, the bottom wall, and the pair of side walls.

Example 6 provides the IC device of any of the preceding examples, where the top wall is in the metal layer of the IC device, the metal layer is over a substrate, and the pair of side walls extend from the metal layer into a substrate.

Example 7 provides the IC device of example 6, the IC device further including a device layer between the substrate and the metal layer, the device layer having a plurality of transistors, where the pair of side walls extend through the device layer.

Example 8 provides the IC device of example 6 or 7, where the metal layer is over a front side of the substrate, and the bottom wall is a portion of a back metallization layer on a back side of the substrate.

Example 9 provides the IC device of any of examples 1-5, where the top wall is in a first metal layer and the bottom wall is in a second metal layer, both the first metal layer and the second metal layer over a support structure of the IC device.

Example 10 provides an IC device that includes an interconnect structure in a layer of the IC device, the interconnect structure including a conductive material; and a waveguide structure at least partially in the layer of the IC device, the waveguide structure including a base including a first conductive material; a top including a second conductive material; and a plurality of vias, each of the plurality of vias extending between the base and the top.

Example 11 provides the IC device of example 10, where the plurality of vias include the second conductive material.

Example 12 provides the IC device of example 10 or 11, where the plurality of vias include a first set of vias arranged in a first row over a first side of the base and a second set of vias arranged in a second row over a second side of the base.

Example 13 provides the IC device of any of examples 10-12, where the first conductive material and the second conductive material include a same metal.

Example 14 provides the IC device of any of examples 10-13, where a dielectric material is within the waveguide structure between the base and the top.

Example 15 provides the IC device of any of examples 10-13, where a semiconductor material is within the waveguide structure between the base and the top.

Example 16 provides the IC device of any of examples 10-15, where the top of the waveguide structure is in the layer of the IC device, and the layer is a metal layer.

Example 17 provides the IC device of example 16, where the plurality of vias extend into a substrate below the metal layer.

Example 18 provides the IC device of example 17, where the base is a portion of a back metallization layer on a back side of the substrate.

Example 19 provides a device that includes a support structure; a metal layer over the support structure, the metal layer including a dielectric material and a conductive material; and a structure at least partially within the support structure and at least partially within the metal layer, the structure including a top wall in the metal layer, the top wall including the conductive material, a bottom wall, and a pair of side walls extending between the top wall and the bottom wall, where a cross-section of the top wall, the bottom wall, and the pair of side walls is substantially rectangular.

Example 20 provides device of example 19, where the dielectric material is inside at least a portion of an area bounded by the top wall, the bottom wall, and the pair of side walls.

Example 21 provides an IC package that includes an IC die, including one or more of the devices according to any one of the preceding examples. The IC package may also include a further component, coupled to the IC die.

Example 22 provides the IC package according to example 21, where the further component is one of a package substrate, a flexible substrate, or an interposer.

Example 23 provides the IC package according to examples 21 or 22, where the further component is coupled to the IC die via one or more first level interconnects.

Example 24 provides the IC package according to example 23, where the one or more first level interconnects include one or more solder bumps, solder posts, or bond wires.

Example 25 provides a computing device that includes a circuit board; and an IC die coupled to the circuit board, where the IC die includes one or more of the memory/IC devices according to any one of the preceding examples (e.g., memory/IC devices according to any one of examples 1-20), and/or the IC die is included in the IC package according to any one of the preceding examples (e.g., the IC package according to any one of examples 21-24).

Example 26 provides the computing device according to example 25, where the computing device is a wearable computing device (e.g., a smart watch) or hand-held computing device (e.g., a mobile phone).

Example 27 provides the computing device according to examples 25 or 27, where the computing device is a server processor.

Example 28 provides the computing device according to examples 25 or 27, where the computing device is a motherboard.

Example 29 provides the computing device according to any one of examples 25-28, where the computing device further includes one or more communication chips and an antenna.

Example 30 provides a method for forming a waveguide, the method including forming a pair of side walls for the waveguide, the side walls extending at least partially into a substrate; forming a waveguide top, the waveguide top in contact with the pair of side walls; and simultaneously with forming the waveguide top, forming an interconnect structure, the interconnect structure and the waveguide top including a metal.

Example 31 provides the method of example 30, where depositing the pair of side walls includes depositing a plurality of vias arranged in two rows, each of the plurality of vias extending into the substrate.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

**Claims**

1. An integrated circuit (IC) device comprising:

   an interconnect structure in a metal layer of the IC device, the interconnect structure comprising a conductive material; and
   a waveguide structure comprising a top wall, a bottom wall, and a pair of side walls, each of the walls comprising the conductive material, wherein one of the top wall and the bottom wall is in the metal layer of the IC device.

2. The IC device of claim 1, wherein the waveguide structure is a rectangular waveguide, and the rectangular waveguide is coupled to a coplanar waveguide.

3. The IC device of claim 2, wherein the one of the top wall and the bottom wall in the metal layer of the IC device is patterned to provide a transition to the coplanar waveguide.

4. The IC device of any of the preceding claims, wherein a dielectric material is in a region bounded by the top wall, the bottom wall, and the pair of side walls.

5. The IC device of any of claims 1-3, wherein a semiconductor material is in a region bounded by the top wall, the bottom wall, and the pair of side walls.

6. The IC device of any of the preceding claims, wherein the top wall is in the metal layer of the IC device, the metal layer is over a substrate, and the pair of side walls extend from the metal layer into the substrate.

7. The IC device of claim 6, the IC device further comprising a device layer between the substrate and the metal layer, the device layer having a plurality of transistors, wherein the pair of side walls extend through the device layer.

8. The IC device of claim 6 or 7, wherein the metal layer is over a front side of the substrate, and the bottom wall is a portion of a back metallization layer on a back side of the substrate.

9. The IC device of any of claims 1-5, wherein the top wall is in a first metal layer and the bottom wall is in a second metal layer, both the first metal layer and the second metal layer over a support structure of the IC device.

10. The IC device of any of the preceding claims, wherein one of the pair of side walls comprises a plurality of vias extending between the top wall and the bottom wall.

11. The IC device of claim 10, wherein the plurality of vias comprise the conductive material.

12. The IC device of claim 10, wherein the plurality of vias comprise a first set of vias arranged in a first row over a first side of the bottom wall, and a second one of the pair of side walls comprises a second set of vias arranged in a second row over a second side of the bottom wall.

13. The IC device of any of the preceding claims, further comprising a support structure, wherein the waveguide structure is at least partially within the support structure.

14. A method for forming a waveguide, the method comprising:

   forming a pair of side walls for the waveguide, the side walls extending at least partially into a substrate;
   forming a waveguide top, the waveguide top in contact with the pair of sidewalls; and
   simultaneously with forming the waveguide top, forming an interconnect structure, the interconnect structure and the waveguide top comprising a metal.

15. The method of claim 19, wherein depositing the pair of side walls comprises depositing a plurality of vias arranged in two rows, each of the plurality of vias extending into the substrate.

**FIG. 1**

**FIG. 2**

| | 102 | | 104 | | 106 | | 108 | | 202 | | 204 |

FIG. 3

| | 102 | | 104 | | 106 | | 108 |

**FIG. 4**

| | 102 | | 104 | | 106 | | 108 |

```
┌─────────────────────────────────────┐
│   Etch region for forming waveguide  │
│                502                   │
└─────────────────────────────────────┘
                    │
                    ▼
┌─────────────────────────────────────┐
│      Deposit conductive material     │
│                504                   │
└─────────────────────────────────────┘
                    │
                    ▼
┌─────────────────────────────────────┐
│             Deposit fill             │
│                506                   │
└─────────────────────────────────────┘
                    │
                    ▼
┌─────────────────────────────────────┐
│   Deposit waveguide top in CMOS metal│
│                process               │
│                508                   │
└─────────────────────────────────────┘
```

**FIG. 5**

**FIG. 6A**

**FIG. 6B**

602  604

**FIG. 6C**

**FIG. 6D**

602   604   606   608

622    624

**FIG. 6E**

630    632

B    B'

**FIG. 6F**

| | 302 | | 304 | | 306 | | 308 | | 310 |

**FIG. 7**

702 ☐  704 ▨  706 ▥  708 ▢

Provide substrate with back metallization
802

Etch via holes through substrate
804

Deposit vias for side walls
806

Deposit waveguide top in CMOS metal
process
808

# FIG. 8

**FIG. 9A**

**FIG. 9B**

**FIG. 9C**

**FIG. 9D**

1500

SEE FIG. 10B

1502

**FIG. 10A**

1502

**FIG. 10B**

**FIG. 11**

FIG. 12

1800

| | |
|---|---|
| PROCESSING DEVICE 1802 | MEMORY 1804 |
| COMMUNICATION CHIP 1806 | ANTENNA 1808 |
| BATTERY/POWER CIRCUITRY 1810 | DISPLAY DEVICE 1812 |
| AUDIO OUTPUT DEVICE 1814 | AUDIO INPUT DEVICE 1816 |
| OTHER OUTPUT DEVICE 1818 | OTHER INPUT DEVICE 1820 |
| GPS DEVICE 1822 | SECURITY INTERFACE DEVICE 1824 |

# FIG. 13

Europäisches
Patentamt

European
Patent Office

Office européen
des brevets

# EUROPEAN SEARCH REPORT

**Application Number**

EP 23 21 0873

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/336637 A1 (DANG BING [US] ET AL) 17 November 2016 (2016-11-17) | 1-6,8-13 | INV.<br>H01P3/12 |
| Y | * paragraph [0021] - paragraph [0029]; | 7 | H01L23/66 |
| A | figures 1A-1C *<br>* paragraph [0039] - paragraph [0056]; figures 2-7 * | 14,15 | H01P5/107 |
| X | US 2023/088545 A1 (DOGIAMIS GEORGIOS [US] ET AL) 23 March 2023 (2023-03-23) | 1,4-6, 8-13 | |
| Y | * paragraph [0019] * | 7 | |
| A | * paragraph [0034] - paragraph [0036]; figures 6A, 6B *<br>* paragraph [0038] - paragraph [0040]; figure 9 *<br>* paragraph [0042] *<br>* paragraph [0048] - paragraph [0049]; figure 13 *<br>* paragraph [0063]; figure 14 * | 14,15 | |
| X | US 2014/320231 A1 (SELER ERNST [DE] ET AL) 30 October 2014 (2014-10-30) | 1,4-6, 8-13 | TECHNICAL FIELDS SEARCHED (IPC) |
| A | * paragraph [0025] - paragraph [0035]; figures 3-5 * | 14,15 | H01P<br>H01L |
| X | US 2022/415830 A1 (ERDOEL TUNCAY [DE] ET AL) 29 December 2022 (2022-12-29)<br>* paragraph [0027] - paragraph [0031]; figure 1A *<br>* paragraph [0044] - paragraph [0047]; figures 3A-3C * | 1-6,8-15 | |
| X | US 2023/084445 A1 (CHEN HUAN-NENG [TW] ET AL) 16 March 2023 (2023-03-16) | 1 | |
| A | * paragraph [0030] - paragraph [0038]; figures 3A, 3B *<br>* paragraph [0044] - paragraph [0047] * | 2-15 | |

The present search report has been drawn up for all claims

| Place of search | Date of completion of the search | Examiner |
|---|---|---|
| The Hague | 1 May 2024 | Pastor Jiménez, J |

EPO FORM 1503 03.82 (P04C01)

## ANNEX TO THE EUROPEAN SEARCH REPORT
## ON EUROPEAN PATENT APPLICATION NO.

**EP 23 21 0873**

This annex lists the patent family members relating to the patent documents cited in the above-mentioned European search report.
The members are as contained in the European Patent Office EDP file on
The European Patent Office is in no way liable for these particulars which are merely given for the purpose of information.

**01-05-2024**

| Patent document cited in search report | Publication date | Patent family member(s) | | Publication date |
|---|---|---|---|---|
| US 2016336637 A1 | 17-11-2016 | CN | 107431064 A | 01-12-2017 |
| | | DE | 112016000846 T5 | 09-11-2017 |
| | | GB | 2551298 A | 13-12-2017 |
| | | JP | 6879925 B2 | 02-06-2021 |
| | | JP | 2018514082 A | 31-05-2018 |
| | | US | 2016276727 A1 | 22-09-2016 |
| | | US | 2016276729 A1 | 22-09-2016 |
| | | US | 2016336282 A1 | 17-11-2016 |
| | | US | 2016336637 A1 | 17-11-2016 |
| | | US | 2016336638 A1 | 17-11-2016 |
| | | WO | 2016145960 A1 | 22-09-2016 |
| US 2023088545 A1 | 23-03-2023 | US | 2019287908 A1 | 19-09-2019 |
| | | US | 2023088545 A1 | 23-03-2023 |
| US 2014320231 A1 | 30-10-2014 | CN | 104124211 A | 29-10-2014 |
| | | DE | 102014105845 A1 | 30-10-2014 |
| | | US | 2014320231 A1 | 30-10-2014 |
| US 2022415830 A1 | 29-12-2022 | DE | 102022115688 A1 | 29-12-2022 |
| | | US | 2022415830 A1 | 29-12-2022 |
| US 2023084445 A1 | 16-03-2023 | DE | 102020108029 A1 | 04-03-2021 |
| | | TW | 202109693 A | 01-03-2021 |
| | | US | 2022336384 A1 | 20-10-2022 |
| | | US | 2023084445 A1 | 16-03-2023 |

EPO FORM P0459

For more details about this annex : see Official Journal of the European Patent Office, No. 12/82